(19) Europäisches Patentamt
European Patent Office
Office européen des brevets

(11) Veröffentlichungsnummer: **0 059 250**
**B1**

(12) # EUROPÄISCHE PATENTSCHRIFT

(45) Veröffentlichungstag der Patentschrift: **04.09.85**

(51) Int. Cl.⁴: **G 03 C 1/495**, G 03 C 1/60, G 03 F 7/02, G 03 F 7/08

(21) Anmeldenummer: **81109000.0**

(22) Anmeldetag: **27.10.81**

(54) **Lichtempfindliches Gemisch und daraus hergestelltes Kopiermaterial.**

(30) Priorität: **26.02.81 DE 3107109**

(43) Veröffentlichungstag der Anmeldung: **08.09.82 Patentblatt 82/36**

(45) Bekanntmachung des Hinweises auf die Patenterteilung: **04.09.85 Patentblatt 85/36**

(84) Benannte Vertragsstaaten: **AT BE CH DE FR GB IT LI NL SE**

(56) Entgegenhaltungen:
**DE - A - 2 512 933**
**DE - A - 2 829 512**

(73) Patentinhaber: **HOECHST AKTIENGESELLSCHAFT, Postfach 80 03 20, D-6230 Frankfurt am Main 80 (DE)**

(72) Erfinder: **Stahlhofen, Paul, Dr., Leibnizstrasse 18/B, D-6200 Wiesbaden (DE)**

**EP 0 059 250 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die Erfindung betrifft ein lichtempfindliches Gemisch aus einer lichtempfindlichen Verbindung oder einer lichtempfindlichen Kombination von Verbindungen und einem halogenierten Novolak, das bei Belichtung seine Löslichkeit in einer wässrig-alkalischen Lösung ändert, und ein lichtempfindliches Kopiermaterial aus einem Schichtträger und einer lichtempfindlichen Schicht, die aus dem angegebenen Gemisch besteht.

Gemische der genannten Gattung, die als lichtempfindliche Verbindungen positiv arbeitende o-Chinondiazide enthalten und bevorzugt zur Herstellung von Druckplatten verwendet werden, sind z.B. aus der DE-C 1 195 166 (= US-A 3 201 239) bekannt. Diese bekannten Gemische enthalten Phenol- oder Kresol-Formaldehyd-Novolake.

Aus der DE-A 2 512 933 ist ein ähnliches Gemisch bekannt, das aber ein Novolakharz aus einem Alkylphenol mit einer Alkylgruppe mit 3–15 Kohlenstoffatomen oder aus einem Cycloalkylphenol enthält. Das Alkylphenol kann weiter durch Halogenatome substituiert sein, doch wird für ein halogensubstituiertes Alkylphenol kein Ausführungsbeispiel angegeben. Die Novolake aus den substituierten Phenolen sollen eine bessere Oleophilie der Bildstellen von Flachdruckplatten und demzufolge eine höhere Druckauflage bewirken. Sie haben allerdings den Nachteil, dass sich damit hergestellte lichtempfindliche Schichten nur mit Entwicklerlösungen entwickeln lassen, die organische Lösungsmittel, z.B. Benzylalkohol, enthalten. Diese Harze werden deshalb im allgemeinen nur in Kombination mit den gebräuchlichen Phenol- oder Kresol-Formaldehyd-Novolaken und vorzugsweise in einer Menge von 1–20 Gew.%, bezogen auf das gesamte Gemisch, angewendet. Es sind auch positiv arbeitende Gemische aus Verbindungen, die bei Belichtung eine Säure abspalten und säurespaltbaren Verbindungen, z.B. Acetalen und Orthocarbonsäureestern, bekannt, die grössere Mengenanteile an Novolaken enthalten. Derartige Gemische sind z.B. in den US-A 4 101 323 und 4 247 611 und der DE-A 2 928 636 beschrieben.

Es sind weiterhin Gemische von Diazoniumsalz-Kondensationsprodukten und Novolaken, z.B. aus der US-A 3 867 147, Beispiele 54 und 61, bekannt.

Flachdruckformen, die aus lichtempfindlichen Flachdruckplatten auf Basis solcher Novolak enthaltender Gemische hergestellt worden sind, zeichnen sich durch hohe Druckauflagen aus. Die Druckschablone solcher Druckformen zeigt jedoch eine gewisse Empfindlichkeit gegenüber Alkohol enthaltenden Feuchtwässern, wie sie in neuerer Zeit häufig verwendet werden. Das hat zur Folge, dass die Druckschablone angegriffen und die Druckauflage herabgesetzt wird. Auch die Resistenz gegenüber wässrig-alkalischen Entwicklerlösungen und Benzinlösungsmitteln, wie sie während der Kopierarbeiten oder an Druckmaschinen verwendet werden, ist in manchen Fällen nicht ausreichend.

Die Resistenz von solchen Druckschablonen kann zwar durch Einbrennen bei Temperaturen oberhalb 180°C erhöht werden, doch erfordert dieser zusätzliche Arbeitsschritt in jedem Fall noch eine Vor- oder eine Nachbehandlung der Druckform und damit einen bestimmten Arbeitsaufwand.

Aufgabe der Erfindung war es, ein lichtempfindliches Gemisch, besonders für die Herstellung von Flachdruckplatten zur Verfügung zu stellen, das die Vorteile der bekannten Gemische hat und zusätzlich eine höhere Resistenz gegenüber Benzinlösungsmitteln, alkalischen Entwicklerlösungen und Alkohol enthaltenden Feuchtwässern aufweist.

Erfindungsgemäss wird ein lichtempfindliches Gemisch aus einer lichtempfindlichen Verbindung oder einer lichtempfindlichen Kombination von Verbindungen und einem halogenierten Novolak vorgeschlagen, das bei Belichtung seine Löslichkeit in einer wässrig-alkalischen Lösung ändert und das dadurch gekennzeichnet ist, dass der Novolak bromierte Phenol- oder Kresoleinheiten enthält.

Der Bromgehalt der Novolake kann im allgemeinen etwa 10 bis 50, bevorzugt etwa 15 bis 50 Gew.% betragen.

Die neuen Novolakharze können 1 bis 3, vorzugsweise nicht mehr als 1 Bromatom in einem Phenolkern enthalten. Die Bromatome stehen bevorzugt in m- oder p-Stellung zur OH-Gruppe. Die Novolake können bromierte und nicht-halogenierte Einheiten enthalten. Die Phenoleinheiten können ausser den Bromatomen Methylgruppen, als Substituenten, ebenfalls vorzugsweise in m- oder p-Stellung, enthalten. Das mittlere Molekulargewicht der Harze beträgt etwa 800 bis 5000.

Die neuen bromierten Novolake können durch Kondensieren von Bromphenolen mit Formaldehyd in gleicher Weise wie die bekannten Novolake hergestellt werden. Die Kondensation erfolgt vorteilhaft in organischen Lösungsmitteln, wie Ethanol, Methoxy- oder Ethoxyethylacetat, Dioxan oder Chlorbenzol, in Gegenwart saurer Kondensationsmittel wie Salzsäure oder Oxalsäure bei einer Temperatur im Bereich von 80 bis 130°C. Die Reaktionsdauer kann in Abhängigkeit von der Temperatur etwa ½ bis 4 Stunden betragen.

Bei der Kondensation können die Bromphenole auch im Gemisch mit halogenfreien Phenolen oder Alkylphenolen eingesetzt werden.

Die bromierten Novolake können mit Vorteil auch durch nachträgliches Bromieren von halogenfreien Novolaken, z.B. handelsüblichen Phenol- oder Kresol-Novolaken, hergestellt werden. Die Bromierung erfolgt zweckmässig in Eisessig bei Raumtemperatur oder bei erhöhter Temperatur, z.B. zwischen 60 und 100°C.

Die Konzentration der bromierten Novolake in dem lichtempfindlichen Gemisch kann je nach der Natur des lichtempfindlichen Systems sehr unterschiedlich sein. Im allgemeinen liegt der Anteil zwischen 10 und 95, vorzugsweise bei 20 bis

80 Gew.%, bezogen auf das Gewicht der nichtflüchtigen Bestandteile des lichtempfindlichen Gemisches.

Das erfindungsgemässe Gemisch enthält als weiteren wesentlichen Bestandteil eine lichtempfindliche Verbindung bzw. eine lichtempfindliche Kombination von Verbindungen, die beim Belichten ihre Löslichkeit in einer wässrig-alkalischen Entwicklerlösung ändert. Geeignete negativ arbeitende Verbindungen sind Diazoniumsalz-Polykondensationsprodukte und p-Chinondiazide. Bevorzugt werden positiv arbeitende Systeme, d.h. solche, deren Löslichkeit durch Belichten erhöht wird. Hierzu gehören vor allem o-Chinondiazide und Kombinationen von photolytischen Säurespendern mit säurespaltbaren Verbindungen.

Als o-Chinondiazide werden bevorzugt Naphthochinon-(1,2)-diazid-(2)-4- oder 5-sulfonsäureester oder -amide. Von diesen werden die Ester, insbesondere die der 5-Sulfonsäuren, besonders bevorzugt. Geeignete Verbindungen dieser Art sind bekannt und z.B. in der DE-C 938 233, den DE-A 2 331 377, 2 547 905 und 2 828 037 beschrieben.

Die Menge an o-Chinondiazidverbindungen beträgt im allgemeinen 3 bis 50, bevorzugt 7 bis 35 Gew.%, bezogen auf die nichtflüchtigen Anteile des Gemischs.

Auch Materialien auf Basis säurespaltbarer Verbindungen lassen sich mit gutem Effekt in dem erfindungsgemässen Gemisch einsetzen.

Kopiermaterialien dieser Art sind bekannt und z.B. in den US-A 3 779 778 und 4 101 323, der DE-C 2 718 254 und den DE-A 2 829 512, 2 829 511 und 2 928 636 beschrieben. Sie enthalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindungen, insbesondere durch Halogenmethylgruppen substituierte s-Triazine.

Von den in der US-A 4 101 323 beschriebenen Orthocarbonsäurederivaten werden insbesondere die Diphenoxymethylether aliphatischer oder aromatischer Hydroxyverbindungen, die N-Diphenoxymethylderivate von Lactamen sowie ganz besonders die Bis-1,3-dioxan-2-yl-ether von aliphatischen Diolen verwendet.

Von den in der DE-C 2 718 254 beschriebenen Polyacetalen werden diejenigen mit aliphatischen Aldehyd- und Dioleinheiten bevorzugt.

Von den in der DE-A 2 928 636 beschriebenen polymeren Orthoestern werden Polymere mit wiederkehrenden 1,3-Dioxa-cyclohex-2-yl-alkylethereinheiten besonders bevorzugt, in denen die Alkylethergruppe durch Ethersauerstoffatome unterbrochen sein kann und bevorzugt an die 5-Stellung des benachbarten Rings gebunden ist.

Der Mengenanteil der säurespaltbaren Verbindungen in dem lichtempfindlichen Gemisch liegt im allgemeinen zwischen 8 und 65, vorzugsweise zwischen 14 und 44 Gew.%, bezogen auf die nichtflüchtigen Bestandteile des Gemischs. Die Menge der Säure abspaltenden Verbindung liegt zwischen 0,1 und 10, vorzugsweise zwischen 0,2 und 5 Gew.%.

Geeignete p-Chinondiazide sind z.B. in der DE-C-1 104 824 (= US-A 3 180 732) beschrieben. Als Diazoniumsalz-Polykondensationsprodukte werden Kondensationsprodukte von aromatischen Diazoniumsalzen und Carbonylverbindungen, vorzugsweise Formaldehyd, verwendet. Geeignete Kondensationsprodukte sind in der DE-C 1 214 086 (= US-C 3 235 384) beschrieben. Bevorzugt werden derartige Kondensationsprodukte, die ausser den Diazoniumsalzeinheiten noch Einheiten von anderen mit Formaldehyd kondensationsfähigen, von Diazoniumgruppen freien Verbindungen, z.B. von aromatischen Aminen, Phenolen, Phenolethern, aromatischen Thioethern, aromatischen Kohlenwasserstoffen, aromatischen Heterocyclen und organischen Säureamiden, enthalten, wie sie in der DE-A 2 024 244 (= US-A 3 867 147) beschrieben sind.

Die erfindungsgemässen Gemische können ausser den bromierten Novolaken noch weitere wasserunlösliche, in wässrig-alkalischen Lösungen lösliche Harze, bevorzugt die hierfür bekannten und üblichen halogenfreien Novolake enthalten. Dabei können von 0 bis 80 Gew.%, vorzugsweise von 0 bis 70 Gew.%, der Menge des bromierten Novolaks durch nicht-halogenierten Novolak ersetzt werden, ohne dass die erhöhte Alkali- und Lösungsmittelresistenz der Schicht verlorengeht. Die Gesamtmenge an Novolak sollte im Bereich der oben für den bromierten Novolak angegebenen Grenzen liegen.

Zusätzlich können noch zahlreiche andere Harze mitverwendet werden, bevorzugt Vinylpolymerisate wie Polyvinylacetate, Polyacrylate, Polyvinylether, Polyvinylpyrrolidone und die Mischpolymerisate der ihnen zugrundeliegenden Monomeren. Der günstigste Anteil an diesen Harzen richtet sich nach den anwendungstechnischen Erfordernissen und dem Einfluss auf die Entwicklungsbedingungen und beträgt im allgemeinen nicht mehr als 20 Gew.% vom alkalilöslichen Harz. In geringen Mengen kann das lichtempfindliche Gemisch für spezielle Erfordernisse wie Flexibilität, Haftung, Glanz, Färbung und Farbumschlag etc. ausserdem noch Substanzen wie Polyglykole, Cellulosederivate wie Ethylcellulose, Netzmittel, Farbstoffe, Haftvermittler und feinteilige Pigmente sowie bei Bedarf UV-Absorber enthalten.

Als besonders vorteilhaft hat sich der Zusatz bestimmter, in der Wärme härtbarer Hydroxymethylphenol-Derivate bewährt, wie es in der DE-A 3 039 926 beschrieben ist. Derartige Kopierschichten erfahren in Gegenwart bromierter Novolake als Bindemittel eine wesentlich verbesserte Hartung auf der Unterlage und verbesserte Alkohol- und Entwicklerresistenz, als sie mit den entsprechenden nicht-bromierten Novolaken erreicht werden.

Die Hydroxymethylphenole können z.B. einer der allgemeinen Formeln I und II

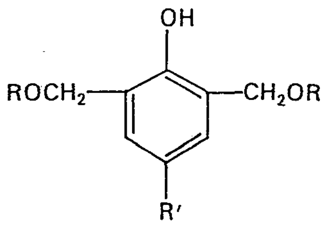

I

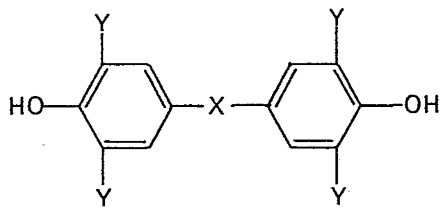

II

entsprechen, worin

R ein Wasserstoffatom, eine niedere Alkylgruppe oder eine niedere Acylgruppe, bevorzugt ein Wasserstoffatom,

R′ eine Alkyl-, Alkoxy-, Cycloalkyl-, Aryl-, Aryloxy-, Acyl-, Aralkylgruppe oder ein Halogenatom,

X eine Einfachbindung oder eine der Gruppen S, O, CO oder $CR^1R^2$, bevorzugt eine Prop-2,2-ylengruppe, und

Y ein Wasserstoffatom oder, vorzugsweise, eine $CH_2OH$-Gruppe

bedeuten, wobei

$R^1$ und $R^2$ gleich oder verschieden sind und Wasserstoffatome, substituierte oder unsubstituierte Alkylgruppen bedeuten, die miteinander zu einem Ring verbunden sein können,

und wobei nicht mehr als zwei der Substituenten Y Wasserstoffatome sind.

Gegenstand der Erfindung ist auch ein lichtempfindliches Kopiermaterial, bestehend aus einem Schichtträger und einer lichtempfindlichen Schicht, die eine lichtempfindliche Verbindung oder eine lichtempfindliche Kombination von Verbindungen und einem halogenierten Novolak, die bei Belichtung ihre Löslichkeit in einer wässrig-alkalischen Lösung ändert, enthält, das dadurch gekennzeichnet ist, dass der Novolak bromierte Phenol- oder Kresoleinheiten enthält.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemässe Gemisch sind Ketone, wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykol-monoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Als Schichtträger für Schichtdicken unter ca. 10 µm werden meist Metalle verwendet. Für Offsetdruckplatten können eingesetzt werden: walzblankes, mechanisch oder elektrochemisch aufgerauhtes und ggf. anodisiertes Aluminium, das zudem noch chemisch, z.B. mit Polyvinylphosphonsäure, Silikaten, Hexafluorozirkonaten, hydrolysiertem Tetraethylorthosilikat oder Phosphaten, vorbehandelt sein kann.

Die Beschichtung des Trägermaterials erfolgt in bekannter Weise durch Aufschleudern, Sprühen, Tauchen, Walzen, mittels Breitschlitzdüsen, Rakeln oder durch Giesser-Antrag.

Belichtet wird mit den in der Technik üblichen Lichtquellen. Auch das Bestrahlen mit Elektronen oder Laser stellt eine Möglichkeit zur Bebilderung dar.

Die zum Entwickeln verwendeten wässrig-alkalischen Lösungen abgestufter Alkalität, d.h. mit einem pH, das bevorzugt zwischen 10 und 14 liegt, und die auch kleinere Mengen organischer Lösungs- oder Netzmittel enthalten können, entfernen bei positiv arbeitenden Gemischen die vom Licht getroffenen Stellen der Kopierschicht und erzeugen so ein positives Abbild der Vorlage. Bei negativ arbeitenden Gemischen werden mit Entwicklern gleicher Art oder solchen mit pH-Werten im neutralen Bereich die unbelichteten Stellen entfernt.

Bevorzugte Anwendung finden die erfindungsgemässen lichtempfindlichen Gemische bei der Herstellung von Druckformen, insbesondere Offsetdruckformen, mit Metallen, insbesondere Aluminium als Schichtträger.

Nach dem Entwickeln kann die Druckform in an sich bekannter Weise erhitzt werden. Bei Zusatz der oben definierten Hydroxymethylphenole ist es möglich, die gewünschte Erhöhung der Druckauflage bei relativ tiefen Temperaturen bzw. innerhalb relativ kurzer Zeiten zu erreichen. Die Einbrenntemperaturen können im Bereich von etwa 150 bis 240°C, vorzugsweise von 160 bis 210°C, gewählt werden, wobei normalerweise Erhitzungszeiten von 1–20, bevorzugt 5 bis 15 Minuten, erforderlich sind. Wenn das Trägermaterial gegen höhere Temperaturen beständig ist, ist es selbstverständlich auch möglich, bei höheren Temperaturen oberhalb 240°C einzubrennen und dementsprechend kurze Erhitzungszeiten zu wählen.

Die unter Verwendung der bromierten Novolake hergestellten Kopiermaterialien besitzen eine verbesserte Resistenz gegenüber alkalischen Entwicklern und Chemikalien, insbesondere alkohol- und benzinhaltigen Lösungsmitteln, wie sie üblicherweise während der Kopierarbeiten oder während des Druckvorganges an den Druckmaschinen verwendet werden. Sie besitzen ferner eine gute Verträglichkeit mit den übrigen Bestandteilen der Kopierschicht.

Die Erfindung wird anhand der nachfolgenden Beispiele näher erläutert, in denen Gewichtsteile (Gt) und Volumenteile (Vt) im Verhältnis von g und $cm^3$ stehen. Prozente sind, wenn nichts anderes angegeben ist, Gewichtsprozente.

Beispiel 1

Mit einer Lösung von

1,00 Gt des Veresterungsproduktes aus 1 Mol 2,3,4-Trihydroxy-benzophenon und 2 Mol Naphthochinon-(1,2)-diazid-(2)-5-sulfonsäurechlorid,
0,14 Gt Naphthochinon-(1,2)-diazid-(2)-4-sulfonsäurechlorid,
2,50 Gt eines bromierten Kresol-Formaldehyd-Novolaks mit einem Erweichungspunkt von 95–110°C und einem Bromgehalt von 39,0 Gew.%,
3,50 Gt eines nicht halogenierten Kresol-Formaldehyd-Novolaks mit einem Erweichungspunkt von 105–120°C und
0,06 Gt Kristallviolett in
40,00 Gt Ethylenglykolmonomethylether und
50,00 Gt Tetrahydrofuran

wurde eine elektrolytisch aufgerauhte und anodisierte Aluminiumplatte mit einem Oxidgewicht von 3,0 g/$m^2$ beschichtet. Der anodisierte Aluminiumträger war vor dem Aufbringen der lichtempfindlichen Kopierschicht mit einer wässrigen Lösung von Polyvinylphosphonsäure behandelt worden, wie es in der DE-C 1 621 478 beschrieben ist.

Das so hergestellte vorsensibilisierte Material mit einem Schichtgewicht der lichtempfindlichen Schicht von 2,00 g/$m^2$ wurde unter einer transparenten Positiv-Vorlage bildmässig belichtet und anschliessend mit der folgenden Lösung entwikkelt:

5,3 Gt Natriummetasilikat × 9 Wasser
3,4 Gt Trinatriumphosphat × 12 Wasser
0,3 Gt Natriumdihydrogenphosphat (wasserfrei) in
91,0 Gt Wasser.

Durch die Entwicklung wurden die vom Licht getroffenen Anteile der Kopierschicht entfernt, und es blieben die unbelichteten Bildstellen auf dem Schichtträger zurück. Von der so hergestellten Druckform wurden in einer Offsetmaschine etwa 200 000 einwandfreie Drucke hergestellt.

Die Druckschablone zeichnete sich durch eine ausgezeichnete Entwicklerresistenz und gute Haftung auf dem Träger aus. Bemerkenswert gut war ferner die Resistenz der Kopierschicht gegenüber Chemikalien, z.B. gegen alkoholhaltige saure Feuchtwässer oder benzinhaltige Auswaschmittel, wie sie üblicherweise während des Druckvorganges an den Druckmaschinen verwendet werden.

Die erwähnten verbesserten Eigenschaften der Kopierschicht sind auf die Gegenwart des halogenierten Novolaks in der Schicht zurückzuführen. Wenn der Anteil des im Beispiel 1 angegebenen bromierten Novolaks durch die gleiche Menge des entsprechenden nicht halogenierten Novolaks bei sonst gleicher Zusammensetzung ersetzt wurde, so wurde nach der Belichtung und Entwicklung eine Druckschablone erhalten, die bereits nach zwei Minuten Einwirkung des Entwicklers stark angegriffen und nach fünf Minuten Einwirkung fast vollständig vom Träger abgelöst war. Im Gegensatz hierzu war die nach Beispiel 1 hergestellte Druckschablone auch nach fünf Minuten Einwirkung des Entwicklers noch nicht angegriffen.

Ähnliche Ergebnisse wurden erhalten, wenn die nach Beispiel 1 hergestellte Kopierschicht, die das bromierte Novolak-Harz enthielt, mit einer sauren, wässrig-alkoholischen Lösung, z.B. bestehend aus 50 Gew.% Isopropanol, 1 Gew.% Phosphorsäure und 49 Gew.% Wasser, behandelt wurde. Beim mechanischen Reiben mit einem mit dieser Lösung getränkten Tampon blieb die Kopierschicht nach Beispiel 1 auch nach einer Minute unverändert, während die entsprechende Kopierschicht mit dem nicht halogenierten Novolak bereits nach 30 Sekunden beschädigt war. Ähnlich unterschiedliche Ergebnisse zeigten die entsprechenden Kopierschichten gegenüber Benzin (Siedebereich 80–110°C) unter gleichen Versuchsbedingungen.

In den folgenden Beispielen werden weitere Beschichtungslösungen angegeben, wobei ähnliche Ergebnisse erhalten wurden. Wenn nicht gesondert vermerkt, entsprechen Herstellung und Verarbeitung der damit erhaltenen Druckplatten den in Beispiel 1 beschriebenen Bedingungen.

Beispiel 2

Mit einer Lösung von

1,50 Gt des Veresterungsproduktes aus 1 Mol 2,3,4-Trihydroxy-benzophenon und 2 Mol Naphthochinon-(1,2)-diazid-(2)-5-sulfonsäurechlorid,
2,50 Gt eines bromierten Phenol-Formaldehyd-Novolaks mit dem Schmelzbereich von 110–125°C und einem Bromgehalt von 39,1 Gew.%,
4,00 Gt eines bromierten Kresol-Formaldehyd-Novolaks mit dem Schmelzbereich von 90–110°C und einem Bromgehalt von 38,9 Gew.%,
0,14 Gt Naphthochinon-(1,2)-diazid-(2)-4-sulfonsäurechlorid und
0,06 Gt Kristallviolett in
40,00 Gt Ethylenglykolmonomethylether und
50,00 Gt Tetrahydrofuran

wurde eine wie in Beispiel 1 behandelte Aluminiumplatte beschichtet. Die so hergestellte lichtempfindliche Druckplatte wurde unter einer transparenten Positiv-Vorlage bildmässig belichtet und mit der im Beispiel 1 angegebenen Lösung entwickelt.

Beispiel 3

Mit einer Lösung von

1,00 Gt des Veresterungsproduktes aus 1 Mol 2,3,4-Trihydroxy-benzophenon und 3 Mol Naphthochinon-(1,2)-diazid-(2)-5-sulfonsäurechlorid,
2,00 Gt eines bromierten Kresol-Formaldehyd-Novolaks mit einem Erweichungspunkt von 90–110°C und einem Brom-Gehalt von 38,9 Gew.%,
0,12 Gt 4-(p-Tolylmercapto)-2,5-diethoxy-benzoldiazoniumhexafluorophosphat,
1,30 Gt 2,2-Bis-(4-hydroxy-3,5-di-hydroxymethyl-phenyl)-propan,
3,00 Gt eines Kresol-Formaldehyd-Novolaks mit einem Erweichungspunkt von 105–120°C und
0,06 Gt Kristallviolett in
40,00 Gt Ethylenglykolmonomethylether und
50,00 Gt Tetrahydrofuran

wurde eine wie in Beispiel 1 vorbehandelte Aluminiumplatte beschichtet. Die so hergestellte lichtempfindliche Druckplatte wurde unter einer transparenten Positiv-Vorlage bildmässig belichtet und mit der im Beispiel 1 angegebenen Lösung entwickelt.

Beispiel 4

Mit einer Lösung von

1,00 Gt des Kondensationsprodukts aus 1 Mol 3-Methoxy-diphenylamin-diazoniumsulfat und 1 Mol 4,4′-Bis-methoxymethyl-diphenylether,
1,00 Gt eines bromierten Phenol-Formaldehyd-Novolaks mit einem Erweichungspunkt von 110–125°C und einem Bromgehalt von 39 Gew.%,
2,50 Gt eines nicht halogenierten Phenol-Formaldehyd-Novolaks mit einem Erweichungspunkt von 83–88°C,
0,05 Gt Metanilgelb (C.I. 13 065),
0,05 Gt Viktoriareinblau FGA (C.I. Basic Blue 81) und
0,10 Gt Phosphorsäure (85%) in
45,00 Gt Ethylenglykolmonomethylether

wurde eine wie in Beispiel 1 vorbehandelte Aluminiumplatte beschichtet. Die so hergestellte lichtempfindliche Druckplatte wurde unter einer transparenten Negativ-Vorlage bildmässig belichtet und mit der im Beispiel 1 angegebenen Lösung entwickelt.

Beispiel 5

Mit einer Lösung von

2,80 Gt einer 50%igen Lösung eines Polyorthoesters in Toluol, hergestellt aus 7,7-Bis-hydroxymethyl-5-oxa-nonanol-(1) und Orthoameisensäuretrimethylester,
0,24 Gt 2,4-Bis-(trichlormethyl)-6-(4-ethoxy-naphth-1-yl)-s-triazin,
1,30 Gt eines bromierten Phenol-Formaldehyd-Novolaks mit einem Erweichungspunkt von 110–125°C und einem Bromgehalt von 46 Gew.%,
3,30 Gt eines bromierten Kresol-Formaldehyd-Novolaks mit dem Erweichungspunkt von 95–110°C und einem Bromgehalt von 46,3 Gew.% und
0,05 Gt Kristallviolett in
80,00 Gt Methylethylketon

wurde eine wie in Beispiel 1 vorbehandelte Aluminiumplatte beschichtet. Die so hergestellte Druckplatte wurde 10 Sekunden unter einer 5 kW-Metallhalogenidlampe im Abstand von 110 cm bildmässig belichtet und anschliessend wie in Beispiel 1 entwickelt.

## Patentansprüche

1. Lichtempfindliches Gemisch aus einer lichtempfindlichen Verbindung oder einer lichtempfindlichen Kombination von Verbindungen und einem halogenierten Novolak, das bei Belichtung seine Löslichkeit in einer wässrig-alkalischen Lösung ändert, dadurch gekennzeichnet, dass der Novolak bromierte Phenol- oder Kresoleinheiten enthält.
2. Lichtempfindliches Gemisch nach Anspruch 1, dadurch gekennzeichnet, dass der bromierte Novolak 15 bis 50 Gew.% Brom enthält.
3. Lichtempfindliches Gemisch nach Anspruch 1, dadurch gekennzeichnet, dass es zusätzlich ein wasserunlösliches, in wässrig-alkalischen Lösungen lösliches Harz enthält, das kein bromierter Novolak ist.
4. Lichtempfindliches Gemisch nach Anspruch 1, dadurch gekennzeichnet, dass es 10 bis 95 Gew.% an bromiertem Novolak enthält.
5. Lichtempfindliches Gemisch nach Anspruch 1, dadurch gekennzeichnet, dass es zusätzlich ein in der Wärme härtbares Hydroxymethylphenol-Derivat enthält.
6. Lichtempfindliches Gemisch nach Anspruch 1, dadurch gekennzeichnet, dass es als lichtempfindliche Verbindung ein o-Chinondiazid enthält.
7. Lichtempfindliches Gemisch nach Anspruch 1, dadurch gekennzeichnet, dass es als lichtempfindliche Kombination ein Gemisch aus

a) einer bei Belichtung Säure abspaltenden Verbindung und

b) einer Verbindung mit mindestens einer durch Säure spaltbaren C-O-C-Gruppe

enthält.

8. Lichtempfindliches Kopiermaterial, bestehend aus einem Schichtträger und einer lichtempfindlichen Schicht, die eine lichtempfindliche Verbindung oder eine lichtempfindliche Kombination von Verbindungen, die bei Belichtung ihre Löslichkeit in einer wässrig-alkalischen Lösung ändert, und einen halogenierten Novolak enthält, dadurch gekennzeichnet, dass der Novolak bromierte Phenol- oder Kresoleinheiten enthält.

## Claims

1. A light-sensitive mixture, which is composed of a light-sensitive compound or of a light-sensitive combination of compounds and of a halogenated novolak, and the solubility of which

in an aqueous-alkaline solution changes on exposure, wherein the novolak contains brominated phenol or cresol units.

2. A light-sensitive mixture as claimed in claim 1, wherein the brominated novolak contains 15 to 50% by weight of bromine.

3. A light-sensitive mixture as claimed in claim 1, which additionally contains a resin which is insoluble in water and soluble in aqueous-alkaline solutions and which is not a brominated novolak.

4. A light-sensitive mixture as claimed in claim 1, which contains 10 to 95% by weight of the brominated novolak.

5. A light-sensitive mixture as claimed in claim 1, which additionally contains a heat-curable hydroxymethylphenol derivative.

6. A light-sensitive mixture as claimed in claim 1, which contains an o-quinone-diazide as the light-sensitive compound.

7. A light-sensitive mixture as claimed in claim 1, which contains, as the light-sensitive combination, a mixture of

a) a compound which splits off an acid on exposure and

b) a compound containing at least one C-O-C group which

can be split by acid.

8. A light-sensitive copying material, composed of a support and a light-sensitive layer which contains a light-sensitive compound or a light-sensitive combination of compounds, and the solubility of which in an aqueous-alkaline solution changes on exposure, and a halogenated novolak, wherein the novolak contains brominated phenol or cresol units.

**Revendications**

1. Mélange photosensible constitué d'un composé photosensible ou d'une combinaison photosensible de composés et d'un Novolak halogéné, dont la solubilité dans une solution alcaline aqueuse est modifiée lors de l'exposition, caractérisé en ce que le Novolak contient des motifs phénol ou crésol bromé.

2. Mélange photosensible selon la revendication 1, caractérisé en ce que le Novolak bromé contient 15 à 50% en poids de brome.

3. Mélange photosensible selon la revendication 1, caractérisé en ce qu'il contient en outre une résine insoluble dans l'eau, soluble dans les solutions alcalines aqueuses, qui n'est pas un Novolak bromé.

4. Mélange photosensible selon la revendication 1, caractérisé en ce qu'il contient 10 à 95% en poids de Novolak bromé.

5. Mélange photosensible selon la revendication 1, caractérisé en ce qu'il contient en outre un dérivé d'hydroxyméthylphénol durcissable à la chaleur.

6. Mélange photosensible selon la revendication 1, caractérisé en ce qu'il contient comme composé photosensible un o-quinonediazide.

7. Mélange photosensible selon la revendication 1, caractérisé en ce qu'il contient comme combinaison photosensible un mélange de:

a) un composé qui libère de l'acide lors de l'exposition et

b) un composé possédant au moins un groupe C-O-C

qui peut être scindé par action d'un acide.

8. Matériau de reproduction photosensible constitué d'un support de couche et d'une couche photosensible, qui contient un composé photosensible ou une combinaison photosensible de composés dont la solubilité dans une solution alcaline aqueuse est modifiée lors de l'exposition et un Novolak halogéné, caractérisé en ce que le Novolak contient des motifs phénol ou crésol bromé.